# EUROPEAN PATENT APPLICATION

(11) **EP 4 057 069 A1**
(43) Date of publication of application: **14.09.2022**
(21) Application number: 21162049.7
(22) Date of filing: 11.03.2021
(51) Int. Cl.: G03F 7/20, G03F 9/00

(54) **METHODS AND APPARATUS FOR CHARACTERIZING A SEMICONDUCTOR MANUFACTURING PROCESS**

(71) Applicant: ASML Netherlands B.V., 5500 AH Veldhoven (NL)
(72) Inventor: KLEIN KOERKAMP, Niek Willem, 5500 AH Veldhoven (NL); HAUPTMANN, Marc, 5500 AH Veldhoven (NL); KEYVANI JANBAHAN, Aliasghar, 5500 AH Veldhoven (NL); WANG, Jingchao, 5500 AH Veldhoven (NL)
(74) Representative: ASML Netherlands B.V.

(57) **Abstract**

Methods and apparatus for characterizing a semiconductor manufacturing process performed on a substrate. First data is obtained associated with fingerprint data of the substrate measured after a first process step. Second data is obtained associated with fingerprint data of the substrate measured after a second processing step. The first and second data are decomposed into a first class of fingerprint components mutually correlating between the first and second data and a second class of fingerprint components not mutually correlating between the first and second data. At least one of the first class fingerprint of components and the second class of fingerprint components are used to characterize the semiconductor manufacturing process.

## Description

### FIELD

The present invention relates to methods and apparatus for characterizing a semiconductor manufacturing process comprising a plurality of process steps. In particular it relates to a decomposition of data obtained during processing steps into correlated and non-correlated classes of fingerprint components.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-kl lithography may be used to process features with dimensions smaller than the classical resolution limit of a lithographic apparatus. In such process, the resolution formula may be expressed as CD = k1×λ/NA, where λ is the wavelength of radiation employed, NA is the numerical aperture of the projection optics in the lithographic apparatus, CD is the "critical dimension" (generally the smallest feature size printed, but in this case half-pitch) and k1 is an empirical resolution factor. In general, the smaller k1 the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

Different types of metrology tools may be used to measure and inspect different characteristics of structures patterned onto substrates and any other properties of the substrate and process. Measurements may be performed on a finalised structure, for example to inspect its quality and/or yield. Measurements may also be made during the manufacturing process. Such measurements may among other things be used to monitor the quality of the structures. Based on the measurements, adjustments or corrections may be made to the lithographic patterning process, for example to fix identified errors, and/or improve future exposures. The links and relations between the metrology data and the adjustments to be applied to the patterning process may be complex and hard to identify. It may furthermore be challenging to identify the cause of any errors or variations in the metrology data. Described herein are methods and apparatus to improve this analysis and characterization of the manufacturing process based on data obtained during different processing steps.

### SUMMARY

According to a first aspect of the current disclosure there is provided a method for characterizing a semiconductor manufacturing process performed on a plurality of substrates. The method comprises obtaining first data associated with fingerprint data of the substrates measured after a first process step. Second data associated with fingerprint data of the substrates measured after a second processing step is obtained. The first and second data are decomposed into a first class of fingerprint components mutually correlating between the first and second data and a second class of fingerprint components not mutually correlating between the first and second data; At least one of the first class of fingerprint components and the second class of fingerprint components are used to characterize the semiconductor manufacturing process.

Optionally, the second data may comprise overlay data.

Optionally, the first data may comprise one or more of overlay data, alignment data, levelling data, substrate geometry data, substrate topography data, metrology tool data, or historic overlay data from a plurality of second substrates which are separate from the substrate.

Optionally, the decomposition of the first and second data may be performed by a model.

Optionally, the model may comprise a partial least squares regression.

Optionally, the partial least squares model may have been trained, wherein the training process comprised an optimization of the number of partial least square components of the model.

Optionally, the partial least squares model may have been trained, wherein the training process included physical shape filtering.

Optionally, the first process step may occur before the second process step.

Optionally, the first process step and the second process step may be the same process step, and the first data may represent one or more properties different from the one or more properties represented by the second data.

Optionally, the first process step and the second process step may be the same, and the first data and second data may be measured using different metrology tools.

Optionally, the plurality of substrates may belong to the same lot of substrates.

Optionally, the first data may have been obtained during after develop inspection, and the second data may have been obtained during after etching inspection.

Optionally, the characterizing the semiconductor manufacturing process may comprise determining one or more root causes of identified errors in the fingerprint.

Optionally, the characterizing the semiconductor manufacturing process may comprise analysis of the yield of the manufactured patterned substrates.

Optionally, the characterizing may be performed offline, separate from the manufacturing process.

Optionally, the characterizing may be performed online, as a monitoring step in the manufacturing process.

Optionally, in response to the monitoring step, an update may be made to the online manufacturing process.

Optionally, based on the characterizing of the semiconductor manufacturing process, one or more adjustments may be provided to the manufacturing process as feedback and/or feedforward control.

According to another aspect of the current disclosure, there is provided an apparatus comprising a non-transitory storage medium and one or more processing, wherein the non-transitory storage medium comprises instructions, which when executed by the one or more processors, cause the processor to perform a method of characterizing a semiconductor manufacturing process as described above.

According to another aspect of the current disclosure, there is provided a metrology apparatus comprising an apparatus as described above.

According to another aspect of the current disclosure, there is provided an inspection apparatus comprising an apparatus as described above.

According to another aspect of the current disclosure, there is provided a lithographic cell comprising an apparatus as described above.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 depicts a flow diagram of steps in a method for characterizing a lithographic manufacturing process;
- Figure 5 depicts an example schematic representation of data being obtained and decomposed into mapped and residual fingerprint components; and
- Figure 6 depicts a schematic representation of example physical shape overlay models.

### DETAILED DESCRIPTION

In the present document, the terms "radiation" and "beam" are used to encompass all types of electromagnetic radiation and particle radiation, including ultraviolet radiation (e.g. with a wavelength of 365, 248, 193, 157 or 126 nm), EUV (extreme ultra-violet radiation, e.g. having a wavelength in the range of about 5-100 nm), X-ray radiation, electron beam radiation and other particle radiation.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

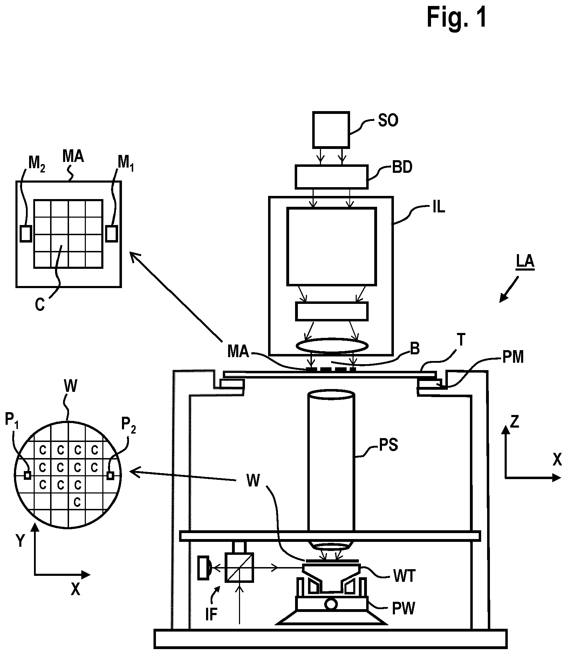

Figure 1 schematically depicts a lithographic apparatus LA. The lithographic apparatus LA includes an illumination system (also referred to as illuminator) IL configured to condition a radiation beam B (e.g., UV radiation, DUV radiation, EUV radiation or X-ray radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, diffractive, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, diffractive, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference in its entirety.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support T, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

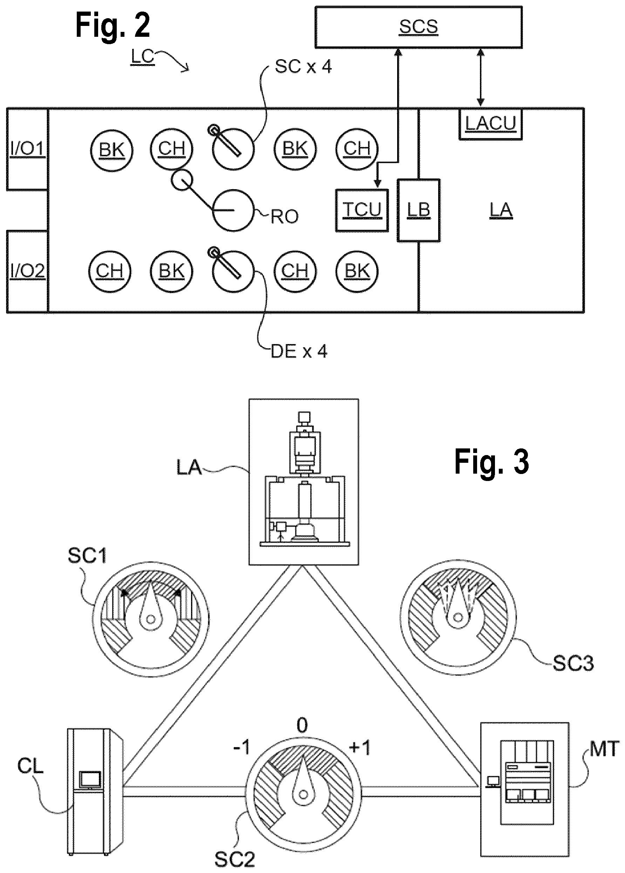

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In lithographic processes, it is desirable to make frequently measurements of the structures created, e.g., for process control and verification. Tools to make such measurement are typically called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in an image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from soft X-ray (SXR), extreme ultraviolet (EUV) and visible to near-infrared (near-IR) wavelength range.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools and/or metrology tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. Typically the pitch and line-width of the structures in the gratings strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resemble the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MET (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Fig. 3 by the arrow pointing "0" in the second scale SC2).

The metrology tool MET may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

Metrology tools MT may be used to quantify and inspect structures that have been patterned onto substrates. Measurements may be obtained during different steps in a lithographic manufacturing process. For example, ADI (after development inspection) and AEI (after etch inspection) type measurements may be performed on the same substrate at different points during the manufacturing process. Measurements may be performed on product features patterned onto a substrate. Measurements may also be performed on metrology targets patterned onto a substrate specifically for metrology and inspection purposes. Different types of metrology targets may be included in a pattern, for enabling different types of measurements. Different targets may be used depending on the type of metrology tool MT and/or the type of parameter to be measured. Parameters to be measured on a substrate may include, but are not limited to, alignment, overlay, and levelling.

Some metrology tools MT are used to measure on-product overlay, for example to quantify the overlap between different layers of a structure patterned onto a substrate. Measured overlay errors are often represented as fingerprints of the overlay error across one or more substrates (wafers). Normally a (overlay) model is used to derive these fingerprints from the measured overlay data. These fingerprints may be decomposed into different components based on their type of error. The decomposition may be based on overlay model spatial frequency characteristics. An example decomposition into components may comprise substrate correctable, field correctable, substrate non-correctable, and field non-correctable. Additionally, the contributions to the total overlay measurement may be split into levels based on where the error can be found. The levels may comprise a spread source decomposition, for example average, lot to lot, and substrate to substrate. The contributions may be used to budget which overlay errors can be corrected for in future exposures. The contributions may alternatively or additionally be used to assess process performance, for example process stability and/or capability.

The correctable and non-correctable components of an overlay error may be at least in part determined by spatial frequency limitations of the applied models used to provide corrections to the process based on the fingerprint. As a result, the decomposition may be useful for assessing the effectiveness of the control of the lithographic patterning process. For example, if the non-correctable component of the error is too large, this may indicate that the model used in the control loop should be changed to include higher spatial frequencies. However, because models may be chosen based on their ability to capture the spatial frequencies of the measured structures the example decomposition described above may be less useful for identifying of root causes and/or quantifying of the contributions of those causes to the error.

Errors on the lithographic patterning process may be identified based on measurements on one or more substrates. The errors may be identified based on variations found between different measurements. Variations may for example be identified between equivalent/corresponding overlay measurements performed on different substrates. Variations may alternatively or additionally be identified between measurements of different types of parameter. However, not all identified variations are indications of patterning errors. The variations may have different causes. These causes may for example include errors in the measurement data, variations caused in differences between metrology tool hardware, different sensitivities to variations by different types of metrology tools MT, patterning errors in metrology targets as opposed to product features, etc. These variations are not representative of errors in the structure patterning process and may be referred to as metrology-induced artefacts. Metrology-induced artefacts do not necessarily correlate to an error in the actual product structure and/or related patterning recipe. Other artefacts may be present in overlay variations, which have a cause not related to substrate overlay variations, and are not indicative of overlay patterning errors.

In order to be able to identify the component of a variation that indicates a correctable error, it may be desirable to achieve root cause identification of the variation. This may in turn allow to determine how contributions to the measured variations can be used for lithographic manufacturing process yield and/or performance. It is therefore an intention of the current application to provide improved and/or more extensive root cause analysis for variations and errors in manufacturing processes.

Another challenge in analysing overlay may be that only sparse overlay metrology data is available for any substrate. The cost in time and metrology tool use of obtaining overlay measurements may be significant, and it may not be feasible to obtain dense overlay metrology data. However, other metrology data (e.g. alignment, levelling, geometry, topography, dose, critical dimension, etc.) may be available for the substrate. It may be possible to infer overlay information from this data. As these data may be obtained using different hardware, metrology-induced artefacts may play a significant role.

In order to identify root causes of overlay errors, and/or to separate substrate variations from artefacts such as metrology-induced artefacts, it is proposed to analyse overlay data of a substrate in relation to other data relating to the substrate. The other data may be referred to as reference data. The reference data may comprise data available for the substrate obtained during an earlier, later, and/or the same processing step. The reference data may alternatively or additionally comprise data relating to other substrates. An analysis of the overlay data and the reference data may be performed to determine which components of the overlay data can be linked to the reference data and which do not have a link. The overlay data may be more generally referred to as second data, as the methods and systems described herein are not limited to analysis of overlay variations, and may be used for analysis of other parameters or properties for characterizing a semiconductor manufacturing process. The methods and systems may be suitable for other complex manufacturing processes comprising a plurality of steps and data.

In an example implementation of an analysis, the methods and systems described herein may try to predict a part of the overlay variation based on the reference data. Based on this prediction the second data may be decomposed into a portion that can be mapped onto (i.e. correlated to) the reference signal, namely the portion that corresponds to the prediction. The second data decomposition may also comprise a portion of the second data that cannot be mapped onto the reference data. If this non-mapped portion is zero, it means that there is no extra variation in overlay introduced between the reference signal and the second signal. Similarly, the non-mapped portion of the decomposition may represent variation in the second signal that has been introduced by the manufacturing process between the reference signal and the second signal. The non-mapped variation may be introduced by manufacturing process steps, but may alternatively or additionally be due to differences between metrology types, metrology artefacts, and/or measurement layout differences.

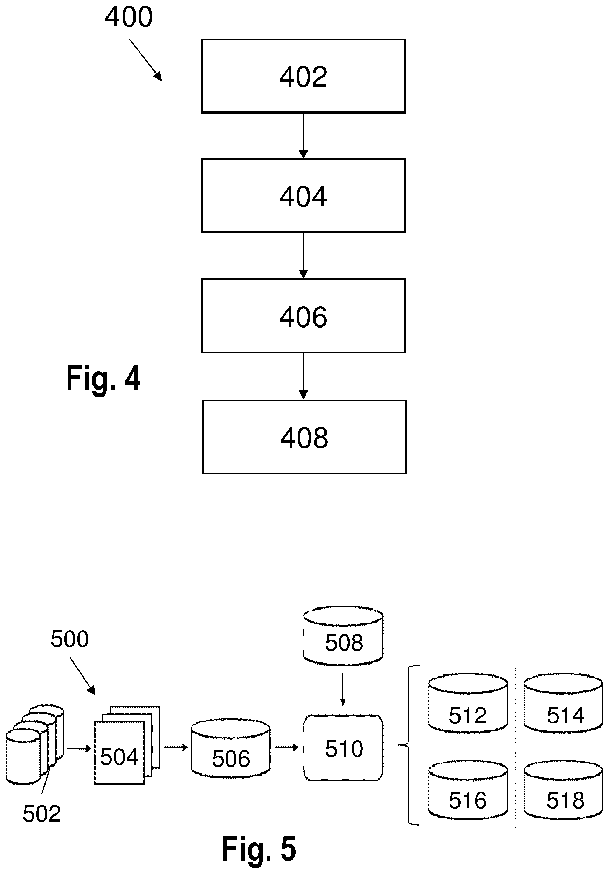

Figure 4 depicts a flow diagram of steps in a method 400 for characterizing a semiconductor manufacturing process. In step 402, first data associated with first data on a plurality of substrates is obtained. The first data may comprise fingerprint data, and/or other data relating to the manufacturing process. The first data may have been measured after a first process step. The first process step may comprise lithographic projection of a pattern onto a substrate (e.g. and development of resist). The first data may be reference data. In step 404, second data associated with second fingerprint data is obtained. The second data is obtained after a second processing step. The second processing step may occur at a later point in the process than the first processing step, at an earlier point in the process than the first processing step, or the first and second processing steps may be the same processing step. The second processing step may for example comprise post-exposure processing of the substrate such as etching and polishing.

In step 406, the first processing data and the second processing data are decomposed into a first class of fingerprint components, and a second class of fingerprint components. The first class of fingerprint components mutually correlates between the first data and second data. The second class of fingerprint components do not mutually correlate between the first data and second data. In step 408 at least one of the first class of fingerprint components and the second class of fingerprint components is used to characterize the semiconductor manufacturing process. Mutually correlated components may also be referred to as mapped components. Components without mutual correlation may also be referred to as residual components. Although they are referred to as first and second fingerprint components, it is possible for these decomposed components to comprise data that are not fingerprint data. This may be because the first and second data may comprise both fingerprint-related and non-fingerprint-related data.

An advantage of the method described above may be that the decomposition allows for the identification of components in the second data that have a correlation with the first data. Due to the differences in metrology tools MT and/or metrology methods used to obtain different types of data for the first and/or second data, a mapping may be required to identify this correlation. The correlation may indicate that the component does not have a cause after the first processing step. This may be used for example to identify a root cause of the correlated component. Knowledge of the manufacturing process may be used to link correlated and non-correlated fingerprint components to root causes. These may have been determined separately and provided to the model for characterization. As used herein, the term correlation may be interpreted to have a general meaning of indicating a connection and/or interdependence. Correlation may be interpreted as having the meaning of the more specific definition of correlation as used in probability and statistics. Correlation may also be interpreted as covariance, for example in the case of a partial least squares PLS regression model described herein.

The second data may comprise overlay data. The first data may be reference data. Reference data may comprise any kind of data related to the semiconductor manufacturing process. Specifically, the reference data may comprise any kind of data that has a relation to the second data. The reference data may be obtained during and/or in relation to the first processing step. The reference data may comprise metrology data obtained after a first processing step. The metrology data may comprise for example overlay data, alignment data, and/or levelling data. The metrology data may comprise for example measurement of any of substrate nano-topography, substrate geometry, critical dimension, dose, etch depth, etch tilt, etch chuck temperature distribution, measurements of the state of the lithographic apparatus LA (e.g. temperature, pressure), measurements of the state of the metrology tool MT, electrical probe data etc.

The origin of the reference data may provide information about where the first class of fingerprint components comes from. The reference data may be associated with a first processing step. The reference data may in some instances relate to multiple different processing steps, wherein the steps may have taken place, before, after, or at the same time as the processing step(s) of the second data. The first and second data may comprise data relating to different properties obtained during the same or different processing steps. In some instances, the first and second data comprise data relating to the same one or more properties, obtained using different metrology tools MT (e.g. metrology tools that use different measurement techniques).

At least some of the characterization of the manufacturing process may be performed by a model. A model may perform the decomposition 406 of first and second data into first and second classes of fingerprint components. The portion of the model responsible for the decomposition step may be referred to as a decomposition module. The first data and the second data may be obtained from a plurality of substrates, for example from a subset of substrates of a lot of substrates.

In order to perform a decomposition of first and second data, such as reference and overlay data, a decomposition module may be trained to map correlations between different data sources. The decomposition module may achieve such mapping for example using a partial least squares PLS regression. A PLS regression may create a model that aims to maximally capture a covariance between input and target data sets, which may be the first and second data respectively. An advantage of using PLS regression may be that it allows flexibility in types of input and output. The types and/or amount (i.e. number of data points per measurement) of first data may be different to the amount and/or type of second data provided to the PLS module. The first data and the second data may have been obtained from the same plurality of substrates. This matches well with the types and/or amount of reference data that may be available compared to the amount of second data. Once trained, a PLS model may be suitable to be used with small data sets. Any other types of suitable model(s) may be used in addition to and/or as an alternative to a PLS module. An example of another type of module may be a neural network.

Training a PLS model may comprise tuning a hyperparameter, namely the number of components. To tune the number of components, training data may be used. The training data may comprise a number of sets comprising first data and second data. The number of training sets may be equal to the number of substrates from which training data are obtained. Each training set may comprise data relating to a single substrate. To tune the hyperparameter, the data may be split into component sets and cross-validation sets. The PLS may be trained multiple times, on the component sets, for different numbers of components. The number of components is changed between 1 and the number of available training sets -1. The remaining training sets are used as a cross-validation set. The PLS model may be trained on the component set, and may then be applied to and tested on the cross-validation set. The model with the best results for the cross-validation set may be selected, and the number of components used to train this model may be selected as the hyperparameter. A root mean square error RMSE may be used to determine the best training model. The RMSE may for example be calculated for each model-determined mapping, and the known second data fingerprint of the cross-validation sets. The above process may be repeated several times, for example for several different groups of training sets and cross-validation sets. Other training methods may be used to select the number of components.

Once the hyperparameter representing the number of components has been selected, the model may be trained using all the training data. The model may be trained to decompose input data into first (mapped) and second (residual) classes of fingerprint components, as described in relation to figure 4 above. The input data may comprise both the first data and the second data. The output of the PLS module may comprise first and second classes of fingerprint components of the first data, and first and second classes of fingerprint components of the second data. The outputs of the PLS module may be provided for characterization of the semiconductor manufacturing process to which the first and second data relate.

Figure 5 depicts an example schematic representation 500 of data being obtained and decomposed into mapped and residual fingerprint components. Data may be obtained from one or more substrates 502. The one or more substrates may for example be a subset of a lot of substrates. A lot of substrates may comprise a plurality (e.g. 25) substrates that are grouped together, going through the same semiconductor manufacturing process. The substrates 502 may in some cases comprise substrates from multiple lots. During one or more second processing steps 504, metrology tools may perform measurements on the one or more substrates 502, including overlay measurements. The overlay measurement data may be grouped and may be pre-processed in step 506. This pre-processing may be performed by an automation system. Pre-processing may involve for example filtering of data corresponding to the edge of the substrates, outlier removal, correction steps, and/or de-correction steps. Pre-processing may include physical shape based filtering, as described in more detail below. Reference data 508, which may have been obtained at one or more processing steps before, at the same time, or after the second processing step(s) 504, are provided in step 508. The pre-processed overlay metrology data and reference data may be provided as input to a model 510. The model may comprise a PLS regression as described above. The model 510 may perform a decomposition of the input into several classes of fingerprint components, namely overlay mapped data 512, reference mapped data 514, overlay residual data 516, and reference residual data 518.

The decomposition of the PLS model into mapped and residual components can be performed on both the correctable and non-correctable components of the overlay variation. The decomposition may also be performed directly on the metrology data, without/before fitting this data to a model to determine correctable/non-correctable components. The PLS model is able to receive a different amount of variables for input and output, which means the metrology data can be used even if it has been measured on different substrate layouts. This makes the decomposition and any characterization based thereon less dependent on the model for determining corrections. The PLS model does not require data types nor data amounts to match between model input and model output. PLS models may also have an advantage of being robust against having a large amount of variables versus observations (e.g. amount of variables >> amount of measured substrates). The PLS model may also be robust against multi-collinearity among variables in the data set. For example, the PLS model may be robust against collinearity between several overlay targets on the susbtrate. A further advantage may be that only a single hyperparameter has to be tuned to determine the model, namely the number of components.

Decompositions of reference and overlay variation data based on model orders, for example using spatial frequencies, may be useful for selecting models that are suitable for describing and representing the data. This may however be less useful for linking the decomposition to production steps. The fingerprint introduced in each step of the manufacturing process may not be separated/identified based on analysis in the spatial frequency domain alone. There may be characteristic properties, such as shapes, that are known through expertise of the manufacturing process, that may be leveraged for further decomposition. Therefore it may be preferable to use one or more different types of decomposition. The decompositions may be designed to comprise a specifically selected combination of basis functions. Each set of basis functions may be suitable to describe a shape that may be linked to a processing step. The determination of expected shapes and their link to one or more specific processing steps may be determined based on expert knowledge and or experimentation data of the manufacturing process. The basis functions may for example comprise Zernike polynomials, and/or any other suitable basis function.

Once the decompositions has been performed, the data may be used to characterize the semiconductor manufacturing process. In some instances, the characterization may be performed offline, that is to say, independently from the semiconductor manufacturing process itself. For example, the characterization may comprise a root cause analysis of on-product overlay variations. Splitting the overlay measurements into components associated with the reference data in itself is a breakdown of the cause of the components. In addition, the characterization may comprise follow-up analysis on each of the components. The follow-up characterization may comprise any type of known budget breakdown methodology, and/or a physical shape based breakdown as described in more detail below.

Characterization may in some instances be implemented as an online application (that is to say during the manufacturing process, e.g. during lithographic projection). Characterization may for example be used for online monitoring of the manufacturing process on-product overlay performance. After it has been trained, a PLS model may perform a decomposition based on a small amount of input. This may make PLS models an advantageous choice as models for online applications, where only a small amount of data may be available. Small and large amounts of data are seen relative to the amount of data available in total. In an example implementation, small may be data related to 1 - 40 substrates, where large may be data related to 40 - 100 substrates. As the amount of available data increases, for example during high volume manufacturing applications, the definitions of small and large may be adjusted accordingly.

Once trained the model mapping, such as the mapping described in relation to figure 5, may be used consistently without requiring retraining for a stable manufacturing process. This may aid in the comparison of different data sets. Based on the online monitoring of a manufacturing process, changes and updates could be made (e.g. applying a correction to the projection system of the lithographic apparatus). This could result in continuous updates to a process, which may lead to longer periods between downtimes required for updates or correcting of the processing systems. In some implementations, it may be possible to update the model in response to new metrology data is input to it, which may eliminate the need for retraining of the model when significant process changes occur.

Characterization of a semiconductor manufacturing process, online or offline, may be used for overlay optimization, alignment optimization, and/or yield improvement. The characterization may lead to recommendations of adjustments/updates to the manufacturing process. The adjustments may for example be provided as feedback and/or feedforward control.

Characterization of semiconductor manufacturing processes described herein may be used for improving lot dispositioning. Based on ADI overlay metrology, it may be possible to judge whether the substrate will be within product specifications after etch (AEI). This may be beneficial, as after development, there is an opportunity to rework the substrate if it does not meet specifications, and reexpose. However, after the etching step has been completed this is no longer possible, and any substrates outside of specifications would have to be scrapped. The PLS model described herein may be adapted so that an input of reference ADI data may be used to determine an estimate of AEI (overlay) data. This estimate may make use of the known correlations and mapping between ADI (reference) and AEI (overlay) data, which the model was trained to identify and decompose.

In an example implementation, the first data, also referred to as reference data, may comprise ADI overlay data. The second data may comprise AEI overlay data. The ADI and AEI data may be de-corrected for any previously applied corrections (e.g. APC corrections). A model mapping between the ADI overlay data and the AEI overlay data may be performed. Root causes of mapped components between these two data types may include top layer lithographic apparatus contributions, and/or bottom layer contributions. Root causes of the residual components for the ADI data may include for example bottom grating asymmetry, target mismatch, layout mismatch, and/or metrology artefacts for the ADI measurements.

Root causes of the residual components for the AEI data may include for example top layer substrate processing, target mismatch, layout mismatch, and/or metrology artefacts for AEI measurements.

In another example implementation, the first data may comprise substrate alignment metrology data, for example obtained during exposure by the lithographic apparatus. The second data may comprise ADI overlay data. The ADI overlay data may have been de-corrected for previously applied corrections (e.g. AL corrections). A model mapping between the substrate alignment and the ADI overlay may be performed. Root causes of mapped components between these two data types may include bottom layer grid deformation. Root causes of the residual components for the alignment data may include for example alignment mark deformation, target mismatch, layout mismatch, and/or metrology artefacts from the alignment measurements. Root causes of the residual components for the ADI overlay data may include for example top layer lithographic apparatus contributions, target mismatch, layout mismatch, and/or metrology artefacts from the ADI measurements.

In another example implementation, the first data may comprise metrology key performance indicators. The second data may comprise AEI and/or ADI overlay data. A model mapping between the metrology key performance indicators and the AEI and/or ADI overlay data may be performed. Root causes of mapped components between these two data types may include overlay impact of key performance indicator variation. Root causes of the residual components for the metrology key performance indicators may include for example residual key performance indicator variation. Root causes of the residual components for the AEI overlay data may include for example residual overlay variation.

The above example implementations are not an exhaustive list, and other mappings between data types from different processing steps, and/or combinations of multiple data type mappings, may be implemented.

Alternatively and/or additionally to the example implementations described above a physical shape based breakdown/filtering may be used to link root causes to decomposed components. The breakdown may comprise fitting physical shape overlay models to the second overlay data, for each substrate individually, and analysing the model content, for example using budget breakdown, temporal behaviour, and/or clustering.

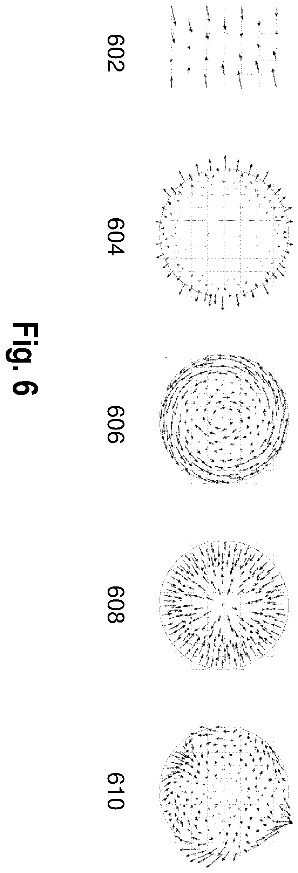

Example physical shape overlay models used in the methodology are depicted in figure 6. The models may match common overlay fingerprints as created by a lithographic apparatus LA or lithographic tool (e.g. substrate processing tool). The depicted model may represent intrafield 602, and interfield (604, 606, 608, 610) physical models, wherein a field represents an exposure field. The interfield physical models may include edge 604, rotation 606, bow 608, and/or swirl 610 (the interfield physical models may represent entire substrates). A lithographic apparatus may be the main contributing main cause for intrafield fingerprint variations, since lithographic exposures take place per field. Knowledge of the lithographic manufacturing process may be used to determine potential root causes for different types of physical shape variations represented by the models of figure 6. Root causes for edge type physical shape variations may for example include etch tilt and/or substrate warp. Root causes for rotation may include for example chemical mechanical polishing CMP. Root causes for bow may include for example etch tilt, lithographic apparatus wafer load grid WLG (substrate deformation resulting from clamping the substrate on the chuck), deposition, and/or substrate warp. Root causes for swirl may include for example anneal, and/or deposition.

Interfield variations may be measured and corrected by substrate alignment. Due to measurement inaccuracies, limited sampling, limited model fidelity, limited actuation range, and/or indirect alignment strategies, it may be that not all interfield fingerprints will be captured and corrected by substrate alignment. Also, effects such as reticle heating and/or wafer heating may be introduced during exposure, and may not be correctable by substrate alignment. Any fingerprints introduced after exposure (e.g. during etch), may not be correctable by alignment, because the process step is later in the process flow.

If, for specific applications, there is a high risk of cross-talk between lithographic apparatus induced effects and the interfield physical shapes, some extra pre-processing may offer a more specific overlay decomposition. This may make use of the PLS mapping method described herein. Such pre-processing may for example isolate specific substrate processing contributions by mapping ADI to AEI overlay. This may extract variations already observed at the ADI measurement stage. Such an approach may allow isolating processing variations introduced between ADI and AEI from the processing variations introduced before ADI. AEI contributions not present at ADI stage exclude lithographic apparatus contributions.

Quantified overlay variation for each physical shape, combined with expert knowledge, and a high-level understanding of the customer process, may allow identification of which root causes are the likely source of overlay variation. An advantage of this methodology may be that it does not impose any additional data requirements other than the availability of several lots of overlay metrology data. This may make the physical shape models decomposition a practical tool for analysis purposes as well as for continuous overlay variation monitoring. It may be used for clustering based on the physical shapes, for example for root cause identification, and/or for process control purposes.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments in the context of a lithographic apparatus, embodiments may be used in other apparatus. Embodiments may form part of a mask inspection apparatus, a metrology apparatus, or any apparatus that measures or processes an object such as a wafer (or other substrate) or mask (or other patterning device). These apparatuses may be generally referred to as lithographic tools. Such a lithographic tool may use vacuum conditions or ambient (non-vacuum) conditions.

Although specific reference may be made in this text to embodiments in the context of an inspection or metrology apparatus, embodiments may be used in other apparatus. Embodiments may form part of a mask inspection apparatus, a lithographic apparatus, or any apparatus that measures or processes an object such as a wafer (or other substrate) or mask (or other patterning device). The term "metrology apparatus" (or "inspection apparatus") may also refer to an inspection apparatus or an inspection system (or a metrology apparatus or a metrology system). E.g. the inspection apparatus that comprises an embodiment may be used to detect defects of a substrate or defects of structures on a substrate. In such an embodiment, a characteristic of interest of the structure on the substrate may relate to defects in the structure, the absence of a specific part of the structure, or the presence of an unwanted structure on the substrate.

Although specific reference may have been made above to the use of embodiments in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target grating and target structure as used herein do not require that the structure has been provided specifically for the measurement being performed. Further, pitch of the metrology targets may be close to the resolution limit of the optical system of the scatterometer or may be smaller, but may be much larger than the dimension of typical non-target structures optionally product structures made by lithographic process in the target portions C. In practice the lines and/or spaces of the overlay gratings within the target structures may be made to include smaller structures similar in dimension to the non-target structures.

Further embodiments of the invention are disclosed in the list of numbered clauses below:
1. A method for characterizing a semiconductor manufacturing process performed on a plurality of substrates, the method comprising: obtaining first data associated with fingerprint data of the substrates measured after a first process step; obtaining second data associated with fingerprint data of the substrates measured after a second processing step; decomposing the first and second data into a first class of fingerprint components mutually correlating between the first and second data and a second class of fingerprint components not mutually correlating between the first and second data; and using at least one of the first class of fingerprint components and the second class of fingerprint components to characterize the semiconductor manufacturing process.
2. A method according to clause 1, wherein the second data comprises overlay data.
3. A method according to clause 1 or 2, wherein the first data comprises one or more of overlay data, alignment data, levelling data, substrate geometry data, substrate topography data, metrology tool data, or historic overlay data from a plurality of second substrates which are separate from the substrate.
4. A method according to clause 1, 2 or 3, wherein the decomposition of the first and second data is performed by a model.
5. A method according to clause 4, wherein the model comprises a partial least squares regression.
6. A method according to clause 5, wherein the partial least squares model has been trained, wherein the training process comprised an optimization of the number of partial least square components of the model.
7. A method according to any of clauses 5 - 6, wherein the partial least squares model has been trained, wherein the training process included physical shape filtering.
8. A method according to any of the preceding clauses, wherein the first process step occurs before the second process step.
9. A method according to any of clauses 1 - 7, wherein the first process step and the second process step are the same process step, and wherein the first data represent one or more properties different from the one or more properties represented by the second data.
10. A method according to any of clauses 1 - 7, or 9 wherein the first process step and the second process step are the same, and wherein the first data and second data are measured using different metrology tools.
11. A method according to any of the preceding clauses, wherein the plurality of substrates belong to the same lot of substrates.
12. A method according to any of the preceding clauses, wherein the first data has been obtained during after develop inspection, and the second data has been obtained during after etching inspection.
13. A method according to any of the preceding clauses, wherein the characterizing the semiconductor manufacturing process comprises determining one or more root causes of identified errors in the fingerprint.
14. A method according to any of the preceding clauses, wherein the characterizing the semiconductor manufacturing process comprises analysis of the yield of the manufactured patterned substrates.
15. A method according to any of the preceding clauses, wherein the characterizing is performed offline, separate from the manufacturing process.
16. A method according to any of the preceding clauses, wherein the characterizing is performed online, as a monitoring step in the manufacturing process.
17. A method according to clause 16, wherein, in response to the monitoring step, an update is made to the online manufacturing process.
18. A method according to any of the preceding clauses, wherein, based on the characterizing of the semiconductor manufacturing process, one or more adjustments are provided to the manufacturing process as feedback and/or feedforward control.
19. An apparatus comprising a non-transitory storage medium and one or more processing, wherein the non-transitory storage medium comprises instructions, which when executed by the one or more processors, cause the processor to perform a method according to any of clauses 1 - 18.
20. A metrology apparatus comprising an apparatus according to clause 19.
21. An inspection apparatus comprising an apparatus according to clause 19.
22. A lithographic cell comprising an apparatus according to clause 19.

While specific embodiments have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference is made to SXR and EUV electromagnetic radiations, it will be appreciated that the invention, where the context allows, may be practiced with all electromagnetic radiations, includes radio waves, microwaves, infrared, (visible) light, ultraviolet, X-rays, and gamma rays. As an alternative to optical metrology methods, it has also been considered to use X-rays, optionally hard X-rays, for example radiation in a wavelength range between O.Olnm and 10nm, or optionally between 0.01nm and 0.2 nm, or optionally between 0.1nm and 0.2nm, for metrology measurements.

## Claims

1. A method for characterizing a semiconductor manufacturing process performed on a plurality of substrates, the method comprising:
obtaining first data associated with fingerprint data of the substrates measured after a first process step;
obtaining second data associated with fingerprint data of the substrates measured after a second processing step;
decomposing the first and second data into a first class of fingerprint components mutually correlating between the first and second data and a second class of fingerprint components not mutually correlating between the first and second data; and
using at least one of the first class of fingerprint components and the second class of fingerprint components to characterize the semiconductor manufacturing process.

2. A method according to claim 1 or 2, wherein the second data comprises overlay data.

3. A method according to any of the preceding claims, wherein the first data comprises one or more of overlay data, alignment data, levelling data, substrate geometry data, substrate topography data, metrology tool data, or historic overlay data from a plurality of second substrates which are separate from the substrate.

4. A method according to claim 1, wherein the decomposition of the first and second data is performed by a model.

5. A method according to claim 4, wherein the model comprises a partial least squares regression.

6. A method according to claim 5, wherein the partial least squares model has been trained, wherein the training process comprised an optimization of the number of partial least square components of the model.

7. A method according to any of claims 5 - 6, wherein the partial least squares model has been trained, wherein the training process included physical shape filtering.

8. A method according to any of the preceding claims, wherein the first process step occurs before the second process step.

9. A method according to any of claims 1 - 7, wherein the first process step and the second process step are the same process step, and wherein the first data represent one or more properties different from the one or more properties represented by the second data.

10. A method according to any of claims 1 - 7, or 9 wherein the first process step and the second process step are the same, and wherein the first data and second data are measured using different metrology tools.

11. A method according to any of the preceding claims, wherein the plurality of substrates belong to the same lot of substrates.

12. A method according to any of the preceding claims, wherein the first data has been obtained during after develop inspection, and the second data has been obtained during after etching inspection.

13. A method according to any of the preceding claims, wherein the characterizing the semiconductor manufacturing process comprises determining one or more root causes of identified errors in the fingerprint.

14. A method according to any of the preceding claims, wherein the characterizing the semiconductor manufacturing process comprises analysis of the yield of the manufactured patterned substrates.

15. An apparatus comprising a non-transitory storage medium and one or more processing, wherein the non-transitory storage medium comprises instructions, which when executed by the one or more processors, cause the processor to perform a method according to any of claims 1 - 14.
